# EUROPÄISCHE PATENTANMELDUNG

(11) **EP 1 890 163 A1**
(43) Veröffentlichungstag der Anmeldung: **20.02.2008**
(21) Anmeldenummer: 07014773.1
(22) Anmeldetag: 27.07.2007
(51) Int. Cl.: G01R 11/04

(54) **Plattform zum Aufstecken eines Stromzählers**

(30) Priorität: 17.08.2006 DE 102006038739
(71) Anmelder: ABB PATENT GmbH, 68526 Ladenburg (DE)
(72) Erfinder: Wieland, Ralf, Dipl.-Ing., 69429 Waldbrunn (DE); Eppe, Klaus-Peter, Dipl.-Ing., 69429 Waldbrunn (DE)
(74) Vertreter: Miller, Toivo

(57) **Zusammenfassung**

Die Erfindung betrifft eine Plattform (10) mit einem rechteckförmigen Gehäuse (101) zum Aufstecken eines Stromzählers (35), mit einer.Abdeckplatte (12) mit Abdeckplattenschlitzen (19, 20) zum Durchstecken von Anschlussfahnen (36, 37) des Stromzählers (35), die in einer Betriebsposition mit Kontakteinrichtungen (13, 14, 15) im Inneren der Plattform (10) in elektrisch leitende Verbindung gelangen, und mit einer zwischen der Abdeckplatte (12) und den Kontakteinrichtungen (13, 14, 15) angeordneten Kontaktplatte (16), die von außerhalb der Plattform (10) zwischen einer Auslieferungs-, einer Montage- und einer Betriebsposition verschiebbar ist, und die Kontaktplattenschlitze (17, 18) aufweist, deren Zusammenwirken mit den Abdeckplattenschlitzen (19, 20) so eingerichtet ist, dass in der Auslieferungsposition die Kontaktplattenschlitze (17, 18) und die Abdeckplattenschlitze (19, 20) seitlich versetzt sind, so dass die Abdeckplattenschlitze (19, 20) durch die Kontaktplatte (16) verdeckt sind, und dass in der Montage- und der Betriebsposition die Kontaktplattenschlitze (17,18) sich unterhalb der Abdeckplattenschlitze (19,20) befinden.

In die Erfindung ist gekennzeichnet durch ein unterhalb der Abdeckplatte (12) angeordnetes, mit der Kontaktplatte (16) zusammenwirkendes und von außerhalb der Plattform (10) zwischen einer Verriegelungsposition und einer Freigabeposition verschiebbares Steuerteil (40), dessen Zusammenwirken mit der Kontaktplatte (16) so eingerichtet ist, dass in der Verriegelungsposition des Steuerteils (40) ein Verschieben der Kontaktplatte (16) aus der Auslieferungs - in die Montageposition und aus der Betriebs - in die Montageposition verhindert ist, und in der Freigabeposition des Steuerteils (40) die Kontaktplatte (16) zur Verschiebung zwischen der Auslieferungs -, der Montage - und der Betriebsposition freigegeben ist.

## Beschreibung

Die Erfindung betrifft eine Plattform mit einem rechteckigen Gehäuse zum Aufstecken eines Stromzählers, gemäß dem Oberbegriff des Anspruchs 1.

Es gibt derzeit Bestrebungen, die elektromechanischen Haushalts Stromzähler durch elektronische Stromzähler zu ersetzen. Diese elektronischen Haushaltszähler (kurz auch EHZ genannt) besitzen an ihrer Befestigungsseite nach unten herausragende Kontaktstifte, die ins Innere eines Adapters oder eine Zählertragplatte eingesteckt und dort mit geeigneten Kontakteinrichtungen in elektrisch leitende Verbindung gebracht werden.

Damit der Austausch eines Stromzählers oder der neue Einbau einfach bewerkstelligt werden kann, ohne dass beim Ausbau beziehungsweise Austausch der Strom zu den Verbrauchern unterbrochen wird, werden Adapter vorgesehen, in denen sich Kontakteinrichtungen befinden. Der Stromzähler wird auf den Adapter dergestalt aufgesetzt, dass die Kontaktstifte durch Schlitze ins Innere des Adapters greifen. Sodann wird der Stromzähler verschoben, wobei gleichzeitig eine elektrische Verbindung innerhalb des Adapters aufgetrennt wird, so dass der Strom, der bei nicht eingebautem Stromzähler über die Kontakteinrichtungen direkt zu den Verbrauchern fließt, nunmehr über den Stromzähler geführt ist.

Ähnliche Ausführungen können auch bei Zählertragplatten in einem Zählerschrank vorgesehen sein.

Insoweit wird unter dem Begriff "Plattform" sowohl ein Adapter zum nachträglichen Einbau in einen Zählerschrank, der ein herkömmliches Zählerkreuz aufweist, als auch eine von vornherein zum Aufsetzen des EHZ vorbereitete Zählertragplatte im Zählerschrank verstanden.

Man unterscheidet bei gattungsgemäßen Plattformen zwischen einer Auslieferungsposition, einer Montageposition und einer Betriebsposition. In der Auslieferungsposition soll es nicht möglich sein, den Stromzähler durch die Schlitze in der Abdeckplatte der Plattform zu stecken. Außerdem sollen die Kontakteinrichtungen im Inneren der Plattform von außen nicht berührt werden können.

In der Montageposition ist es möglich, den Stromzähler durch die Schlitze in der Abdeckplatte der Plattform zu stecken. Sie sind in dieser Position zunächst noch nicht mit den Kontakteinrichtungen verbunden. Die Kontakteinrichtungen sind untereinander noch durch Überbrückungselementen verbunden, so dass der Strom innerhalb des Adapters von der Eingangs- zur Ausgangsseite über die Kontakteinrichtungen und die Überbrückungselemente geleitet wird, ohne zunächst den Stromzähler noch zu durchfließen.

In der Arbeitsposition ist der Stromzähler parallel zu der Abdeckplatte der Plattform verschoben, so dass nun die Anschlussfahnen des elektronischen Stromzählers mit den Kontakteinrichtungen in Verbindung stehen und gleichzeitig die Überbrückungselemente so verschoben sind, dass sie die Kontakteinrichtungen nicht mehr überbrücken.

Eine gattungsgemäße Plattform ist beispielsweise aus der DE 10 2004 054 175 A1 bekannt. Dort ist zwischen der Abdeckplatte und den Kontakteinrichtungen eine Kontaktplatte angeordnet, welche ebenfalls mit Schlitzen versehen ist, die mit den Anschlussfahnen des elektronischen Stromzählers korrespondieren.

Im Auslieferungszustand befindet sich diese Kontaktplatte in der Auslieferungsposition. Sie überdeckt dann die Schlitze in der Abdeckplatte. Der Stromzähler kann nicht durch die Schlitze in der Abdeckplatte gestickt werden, und die Kontakteinrichtungen sind nicht durch die Schlitze in der Abdeckplatte zugänglich.

Bei der bekannten Plattform gemäß der DE 10 2004 054 175 A1 ist im Auslieferungszustand die Kontaktplatte mittels einer an ihr angebrachten und aus der Plattform herausragenden Zunge mit der Plattform plombierbar.

Zur Vorbereitung der Montage des Stromzählers, also zum Verbringen in die Montageposition, ist die Kontaktplatte parallel zur Abdeckplatte des Adapters in die Montageposition verschiebbar. Nach Verschieben der Kontaktplatte in ihre Montageposition befinden sich die Schlitze der Kontaktplatte unterhalb der Schlitze der Abdeckplatte. In dieser Position kann nun der Stromzähler mit seinen Anschlussfahnen durch die Schlitze in der Abdeckplatte und die Schlitze in der Kontaktplatte gesteckt werden.

Um den Stromzähler dann in die Arbeitsposition zu bringen, wird er aus der Montageposition noch einmal parallel zu der Abdeckplatte in Arbeitsposition hin verschoben. Bei diesem Verschiebevorgang nimmt der Strömzähler über seine Anschlussfahnen die Kontaktplatte mit. Die Kontaktplatte wiederum nimmt über an ihr befindliche Transportansätze, die mit entsprechenden Ausnehmungen an den Überbrückungselementen in Eingriff stehen, diese Überbrückungselemente mit und verbringt sie in eine Position, in der die Kontakteinrichtungen nicht mehr durch die Überbrückungselemente überbrückt sind.

Der Vorteil von gattungsgemäßen Plattformen zur Verwendung mit elektronischen Haushaltszählern liegt darin, dass bei einem Wechsel des Haushaltszählers keine Unterbrechung der Stromversorgung in den nachgeschalteten Stromkreisen des Verbrauchers stattfindet. Allerdings bieten gattungsgemäße Plattformen auch gewisse Manipulationsmöglichkeiten für den Verbraucher. Insbesondere könnten Verbraucher versucht werden, den elektronischen Haushaltszähler auf der gattungsgemäßen Plattform zumindest zeitweise aus der Betriebsposition in die Montageposition zu bringen, so dass dann der von ihnen verbrauchte Strom nicht durch den Zähler erfasst würde. Ebenfalls könnten Verbraucher, bei denen der Stromzähler entfernt und die Plattform in den Auslieferungszustand versetzt wurde, und die daher nicht mehr oder noch nicht zum Bezug elektrischer Energie berechtigt sind, versucht werden, die Plattform aus der Auslieferungsstellung in die Montageposition zu bringen, um so unberechtigterweise Strom aus dem Versorgungsnetz entnehmen zu können, ohne ihn zahlen zu müssen.

Es ist daher die Aufgabe der vorliegenden Erfindung, eine gattungsgemäße Plattform so weiterzuentwickeln, das Missbrauchs- und Manipulationsmöglichkeiten bei gattungsgemäßen Plattformen in Verbindung mit elektronischen Haushaltszählern erschwert werden.

Die Aufgabe wird gelöst durch eine gattungsgemäße Plattform mit den kennzeichnenden Merkmalen des Anspruchs 1.

Erfindungsgemäß also ist unterhalb der Abdeckplatte der Plattform zusätzlich zu der Kontaktplatte ein Steuerteil angeordnet, welches mit der Kontaktplatte zusammenwirkt und welches von außerhalb der Plattform zwischen einer Verriegelungsposition und einer Freigabeposition verschoben werden kann. Das Zusammenwirken des Steuerteils mit der Kontaktplatte ist so eingerichtet, dass in der Verriegelungsposition des Steuerteils ein Verschieben der Kontaktplatte aus der Auslieferungs- in die Montageposition beziehungsweise aus der Betriebs- in die Montageposition verhindert ist, und dass nur in der Freigabeposition des Steuerteils die Kontaktplatte zur Verschiebung zwischen der Auslieferungs-, der Montage - und der Betriebsposition freigegeben ist.

Der Vorteil der erfindungsgemäß ausgestalteten Plattform liegt also darin, dass über das Steuerteil ein unbefugtes Verschieben der Kontaktplatte und damit des Haushaltszählers verhindert werden kann.

Gemäß einer vorteilhaften Ausgestaltung der Erfindung ist das Steuerteil als eine Steuerplatte ausgebildet. Sie ist dann Vorteilhafterweise sehr flach und passt bei Einhaltung der vorgeschriebenen Außenmaße gut in den Raum unterhalb der Abdeckplatte der Plattform zwischen die Kontaktplatte und die Abdeckplatte.

Weiterhin vorteilhaft ist eine Ausgestaltung, bei der das Verschieben der Kontaktplatte parallel zur Längserstreckungsrichtung der Plattform und das Verschieben der Steuerplatte senkrecht zur Verschieberichtung der Kontaktplatte erfolgt. Dann kann die Steuerplatte platzsparend im bei aufgesetzter Plattform oberen Teil der Plattform vorgesehen werden.

Sehr vorteilhaft ist weiterhin eine Ausgestaltung, nach der das Verschieben der Kontaktplatte zwischen der Auslieferungs- und der Montageposition mittels eines Werkzeugs durchgeführt wird, welches durch eine Kontaktplattenverstellöffnung in der Abdeckplatte in einen Kontaktplattenverstellschlitz in der Kontaktplatte einführbar ist, und nach der weiterhin das Verschieben der Steuerplatte zwischen der Verriegelungs- und der Freigabeposition ebenfalls mittels eines Werkzeugs erfolgt, welches durch eine Steuerplattenverstellöffnung in der Abdeckplatte in einen Steuerplattenverstellschlitz in der Steuerplatte einführbar ist. Der Vorteil dieser Ausführungsform liegt in der einfachen Handhabbarkeit durch autorisierte Personen.

In weiterhin vorteilhafter Ausführung ist die Steuerplatte so gestaltet und relativ zur Kontaktplatte angeordnet und verschiebbar, dass in der Auslieferungsposition der Kontaktplattenverstellschlitz in der Kontaktplatte durch die Steuerplatte verdeckt ist. Dadurch ist in der Auslieferungsposition der Zugang des Werkzeugs zum Kontaktplattenverstellschlitz blockiert. Die Kontaktplatte kann also nicht aus ihrer Auslieferungsposition heraus in die Montageposition verschoben werden.

Weiterhin vorteilhaft kann die Steuerplatte Steuerplattenverriegelungsmittel um die Kontaktplatte Kontaktplattenverriegelungsmittel umfassen. In der Verriegelurigsposition der Steuerplatte stehen diese erfindungsgemäß miteinander so in Eingriff, dass eine Bewegung der Kontaktplatte relativ zur Steuerplatte verhindert ist. Somit ist auf eine zweite Art in der Verriegelungsposition eine Verschiebung der Kontaktplatte aus der Auslieferungsposition in die Montageposition verhindert.

Weiterhin vorteilhaft kann die Steuerplatte Steuerplattenplombiermittel umfassen, mittels derer sie in ihre Verriegelungsposition mit Plattformplombiermitteln der Plattform plombierbar ist. Dies ist erfindungsgemäß eine dritte Möglichkeit, um unbefugtes Verschieben der Kontaktplatte aus der Auslieferungsposition in die Montageposition zu verhindern.

Erfindungsgemäß ist eine besonders vorteilhafte Ausführungsform dadurch gegeben, dass die Steuerplatte wenigstens zwei solcher Steuerplattenplombiermittel umfasst, mittelst derer sie in ihre Verriegelungsposition mit wenigstens zwei Plattformplombiermitteln der Plattform plombierbar ist. Auf diese Weise ist eine mehrfache Plombierungsmöglichkeit gegeben, was die unberechtigte Stromentnahme weiter erschwert.

Erfindungsgemäß kann auch die Kontaktplatte Kontaktplattenplombiermittel umfassen, mittelst derer sie in ihrer Auslieferungsstellung mit der Plattform plombierbar ist. Dies bietet eine dritte Plombierungsmöglichkeit, so dass die unberechtigte Stromentnahme noch zusätzlich erschwert wird.

In besonders vorteilhafter Ausführungsform ist das Steuerteil ein T-förmiges, flaches Bauteil, dessen erste Querbalken quer zur Schmalseite des Gehäuses der Plattform, und dessen zweiter Querbalken parallel zur Verschieberichtung der Kontaktplatte verläuft. Dadurch ist es möglich, das Steuerteil in den Raum zwischen der Abdeckplatte des Plattformgehäuses und der Kontaktplatte noch einzufügen, ohne dass die äußeren Maße der Plattform geändert werden müssen. Dies ist wichtig, da die äußeren Abmessungen der Plattform durch eine Norm festgelegt sind.

Bei der erfindungsgemäß vorteilhaften Ausgestaltung des Steuerteils und der Kontaktplatte kann das Steuerplattenverriegelungsmittel einen an den zweiten Querbalken des Steuerteils angeformten Steg umfassen, und das Kontaktplattenverriegelungsmittel, welches mit dem Steuerplattenverriegelungsmittel in der Verriegelungsposition zusammenwirkt, umfasst wenigstens eine Ausnehmung in der Längsseite der Kontaktplatte. Insbesondere vorteilhaft ist es erfindungsgemäß dann, wenn zwei Ausnehmungen an der Längsseite der Kontaktplatte vorgesehen sind und derart in Abstand voneinander angeordnet sind, dass in der Auslieferungsposition der Kontaktplatte der Steg mit der ersten Ausnehmung, und in der Betriebsposition der Kontaktplatte der Steg mit der zweiten Ausnehmung in Eingriff steht.

Zusätzlich kann der Steg noch so an der Steuerplatte angeordnet und ausgebildet sein, dass er den Kontaktplattenverstellschlitz in der Kontaktplatte verdeckt, wenn sich die Kontaktplatte in der Plombierposition befindet und die Steuerplatte sich in der Verriegelungsstelle befindet. Damit wären dann zwei unabhängige Plombiermöglichkeiten durch nur ein Bauteil ermöglicht.

Eine mögliche und sehr vorteilhafte Ausgestaltungsart für das erste Steuerplattenplombiermittel sieht vor, dass an einem freien Ende des Querbalkens der Steuerplatte ein in Richtung auf die Freigabeposition hin offener Schlitz vorhanden ist. In dem Gehäuse ist dann ein bewegbarer Finger beweglich gelagert und durch eine Antilux-Öffnung in der Abdeckplatte der Plattform mittels eines Antilux Werkzeugs zwischen einer Sperrposition und eine Öffnungsposition bewegbar. Der Finger und der Schlitz der Steuerplatte sind so relativ zueinander angeordnet und ausgerichtet, dass in der Sperrposition des Fingers dieser die Steuerplatte in der Verriegelungsposition festhält, und in der Öffnungsposition des Fingers dieser und der Schlitz gegeneinander verschiebbar sind. Der Schlitz kann dabei beim Verschieben der Steuerplatte aus der Verriegelungsposition in die Freigabeposition über den Finger gleiten.

Als zweites Steuerplattenplombiermittel kann in der Steuerplatte eine Zunge mit einer Plombieröffnung vorgesehen sein, die mit einer an dem Gehäuse der Plattform angeformten Lasche mit einer weiteren Plombieröffnung so zusammenwirkt, dass in der Verriegelungsposition der Steuerplatte die Plombieröffnung an der Zunge und die weitere Plombieröffnung an der Lasche miteinander fluchten und durch einen Plombierdraht miteinander plombierbar sind.

Zur Plombierung der Kontaktplatte kann gemäß einer besonderen Ausgestaltung der Erfindung eine Ausnehmung in der Kontaktplatte vorgesehen sein, die in der Auslieferungsposition der Kontaktplatte durch eine Öffnung im Gehäuse der Plattform für ein Plombierschloss zugänglich ist. Mit diesem Plombierschloss wird die Kontaktplatte in der Auslieferungsposition mit der Plattform zusätzlich plombiert.

Insgesamt liegen die Vorteile der erfindungsgemäßen Plattform in einer mehrfach redundanten Plombiermöglichkeit.

Weitere vorteilhafte Ausgestaltungen und Verbesserungen der Erfindung und weitere Vorteile sind den Unteransprüchen zu entnehmen.

Anhand der Zeichnungen, in denen ein Ausführungsbeispiel der Erfindung dargestellt sind, sollen die Erfindung sowie weitere vorteilhafte Ausgestaltungen und Verbesserungen der Erfindung näher erläutert und beschrieben werden.

Es zeigen:
- Figur 1:: eine Plattform gemäß dem Stand der Technik im Auslieferungszustand,
- Figur 2:: eine Plattform gemäß dem Stand der Technik in der Montageposition,
- Figur 3:: eine Plattform gemäß dem Stand der Technik in der Arbeitsposition,
- Figur 4:: eine Aufsicht auf den oberen Teil einer erfindungsgemäßen Plattform,
- Figur 5:: eine Aufsicht auf den oberen Teil einer erfindungsgemäßen Plattform bei entfernter Abdeckplatte
- Figur 6:: eine schematische Aufsicht auf den oberen Teil einer erfindungsgemäßen Plattform bei entfernter Abdeckplatte, die Kontaktplatte befindet sich in der Auslieferungsposition, die Steuerplatte befindet sich in der Verriegelungsposition,
- Figur 7:: eine schematische Aufsicht wie in Figur 6, die Kontaktplatte befindet sich in der Auslieferungsposition, die Steuerplatte befindet sich in der Freigabeposition,
- Figur 8:: eine schematische Aufsicht wie in Figur 7, die Kontaktplatte befindet sich in der Montageposition, die Steuerplatte befindet sich in der Freigabeposition,
- Figur 9:: eine schematische Aufsicht wie in Figur 8, die Kontaktplatte befindet sich in der Arbeitsposition, die Steuerplatte befindet sich in der Freigabeposition, sowie
- Figur 10:: eine schematische Aufsicht wie in Figur 9, die Kontaktplatte befindet sich in der Arbeitsposition, die Steuerplatte befindet sich in der Verriegelungsposition.

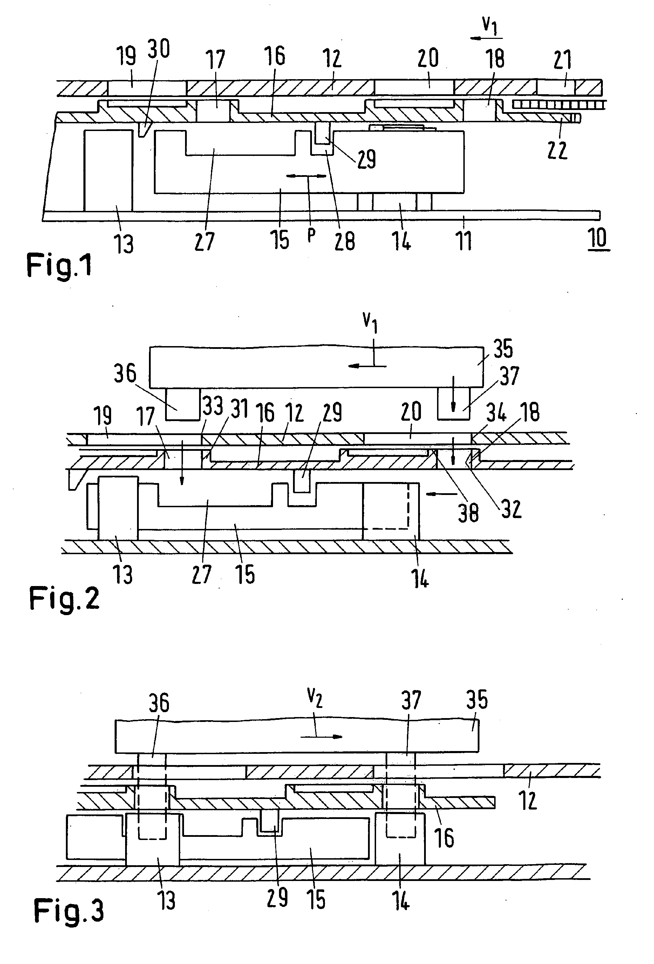

Anhand der Figuren 1 bis 3 soll zum besseren Verständnis der Erfindung noch einmal kurz der Stand der Technik erläutert werden. Eine Plattform 10 besitzt ein napfartiges Gehäuseunterteil 11, welches mit einer Abdeckplatte 12 verschlossen ist. Die Abdeckplatte kann mittels Rastarmen auf das Gehäuseunterteil 11 aufgesetzt und daran verrastet werden. Im Gehäuseunterteil 11 befinden sich in Abstand zueinander angeordneten, etwa U-förmige Kontakttulpen 13 und 14, die jeweils in nicht näher dargestellter Weise mit Zugangsklemmen am Gehäuse 10 verbunden sind.

Den Kontakttulpen 13,14 jeder Phase ist je eine Brücke 15 aus Flachbandmaterial, vorzugsweise aus Kupfer, zugeordnet, die, wie weiter unten noch erläutert werden soll, in Doppelpfeilrichtung P verschoben wird. In der in Figur 1 gezeigten Auslieferungsposition befindet sich die Brücke 15 zwischen den Schenkeln der Kontakttulpe 14 und ist von der Kontakttulpe 13 getrennt. Die Brücke 15 ist mit ihren flach Seiten senkrecht zum Boden und damit etwa parallel zu den Schenkeln der Kontakttulpen 13,14 angeordnet, welche ebenfalls etwas senkrecht zum Boden des Gehäuseunterteils 11 ausgerichtet sind.

Der die Schenkel verbindende Steg der Kontakttulpen 13,14 verläuft parallel zum Boden. Die Kontakttulpen 13,14 jeder Phase sind über Leiter (nicht dargestellt) mit Zu - und Abgangesklemmen verbunden.

Zwischen den Kontakttulpen 13 und 14 sowie der Brücke 15 und der Abdeckplatte 12 befindet sich eine Kontaktplatte 16, die jeweils pro Phase ein Kontaktplattenschlitz-Paar mit Kontaktplattenschlitzen 17,18 aufweist, welche einen Abstand voneinander einnehmen, gemessen in der Verschieberichtung P der Brücke 15, der dem Abstand der Kontakttulpen 13, 14, ebenfalls gemessen in der Verschieberichtung, entspricht.

Oberhalb der Kontakttulpen 13 und 14 befinden sich in der Abdeckplatte 12 Abdeckplattenschlitze 19, 20, deren Länge dem Verschiebeweg P der Brücke 15 entspricht, siehe auch weiter unten. Weiterhin befindet sich in der Abdeckplatte 12 eine Kontaktplattenverstellöffnung 21 und unter der Kontaktplattenverstellöffnung 21 in der Kontaktplatte 16 ein Kontaktplattenverstellschlitz 22.

Wie aus Fig. 1 hervorgeht, besitzt die Brücke auf der der Kontaktplatte 16 bzw. der Abdeckplatte 12 zugewandten Längskante zwei Brückenaussparungen 27, 28, von denen die erste Brückenaussparung 27, in Verschieberichtung der Brücke 15 gemessen, länger ist als die zweite Brückenaussparung 28. Der Grund hierfür wird weiter unten näher erläutert. Auf der der Kontakteinrichtung zugewandten Seite besitzt die Kontaktplatte 16 einen ersten Kontaktplattenvorsprung 29, welcher im montierten Zustand in die zweite Brückenaussparung 28 eingreift. Darüber hinaus ist ein zweiter Kontaktplattenvorsprung 30 vorgesehen, der sich außerhalb der Brücke 15 befindet und der beim Verschieben der Kontaktplatte 16 zwischen die Arme der Kontakttulpen 13 eingreift und diese geringfügig aufweitet, so dass das Einschieben der Brücke 15 in die Kontakttulpe 13 erleichtert wird.

Die Fig. 1 zeigt nun die Anordnung in der Auslieferungsstellung. Hierbei befindet sich die Brücke 15 nur zwischen den Schenkeln der Kontakttulpe 14 und ist von der Kontakttulpe 13 getrennt. Die Kontaktplattenschlitz der 17 und 18 befinden sich außerhalb der Abdeckplattenschlitze 19 und 20 unterhalb der Abdeckplatte 12 und werden von dieser gegen Zugriff von außen abgedeckt.

Wenn die Plattform aus der Auslieferungsstellung gemäß Fig. 1 in die Montageposition, in der ein Stromzähler 35 montiert werden kann, verbracht werden soll, dann werden mittels eines Werkzeuges, z.B. eines Schraubendrehers welches durch die Kontaktplattenverstellöffnung 21 in den Kontaktplattenverstellschlitz 22 eingeführt werden kann, mit manueller Kraft die Kontaktplatte 16 und die Brücke 15 (ebenso die Brücken der anderen Phasen) verschoben, bis die Kontaktplattenschlitz ab 17 und 18 sich unterhalb der Abdeckplattenschlitze 19 und 20 befinden; in diesem Falle steht die Brücke 15 sowohl mit der Kontakttulpe 13 als auch mit der Kontakttulpe 14 in elektrisch leitender Verbindung. Die Brücke 15 ist bei der Verschiebung der Kontaktplatte 16 mittels des in die zweite Brückenaussparung 28 eingreifenden ersten Kontaktplattenvorsprunges 29 in Pfeilrichtung V₁ verschoben worden; der Verschiebeweg ist durch die Länge der Kontaktplattenverstellöffnung 21, gemessen in Verschieberichtung, definiert und so, dass die der Kontaktplattenverstellöffnung 21 benachbarte Endkanten 31 und 32 der Kontaktplattenschlitze 17 und 18 sich an den ebenso der Kontaktplattenverstellöffnung 21 zugewandten Endkanten 33, 34 des Abdeckplattenschlitzes befinden und etwa damit fluchten. Damit kann der elektrische Stromzähler 35 mit seinen Anschlussfahnen 36 und 37 zunächst durch die Abdeckplattenschlitze 19 und 20 und dann durch die Kontaktplattenschlitze 17 und 18 hindurch, die Abdeckplatte 12 durchgreifend, gesteckt werden. Dadurch, dass die erste Brückenaussparung 27 eine entsprechend bemessene Länge besitzt, gelangt die Anschlussfahne 36 des Stromzählers nicht in Berührung mit der Brücke 15; darüber hinaus befindet sich der Anschlussstift 37 auch außerhalb der Tulpe 14.

Wenn nun nach Einschieben der Anschlussfahnen 36 und 37 durch die Abdeckplattenschlitze 19, 20 und die Kontaktplattenschlitze 17, 18 der Stromzähler 35 in Pfeilrichtung V₁ verschoben wird, dann nehmen die Anschlussfahnen 36 und 37 die Abdeckplatte 12 mit und über den ersten Kontaktplattenvorsprung 29 wird auch die Brücke 15 in gleiche Richtung mitgenommen, solange, bis sich die Anschlussfahnen 36, 37 des Stromzählers 35 in den Kontakttulpen 13, 14 befinden. Bei der Montagestellung gemäß Fig. 2 fließt der Strom über die Kontaktbrücke 15 und nicht durch den Stromzähler 35, und nach Verschieben in Pfeilrichtung V₁ in die Stellung gemäß Fig. 3 steht die Kontaktbrücke 15 lediglich mit der Kontakttulpe 13 in elektrisch leitender Verbindung, nicht aber mit der Kontakttulpe 14, so dass der Strom in dieser Stellung durch den Stromzähler hindurchfließt.

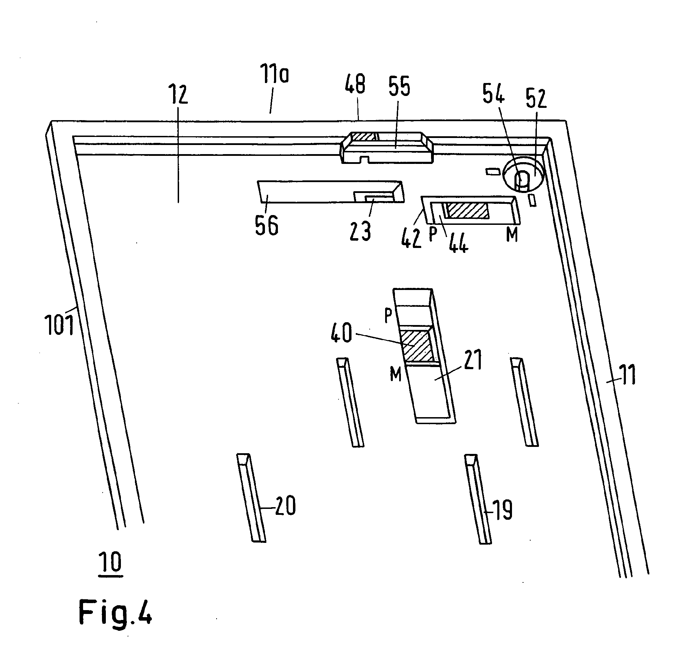

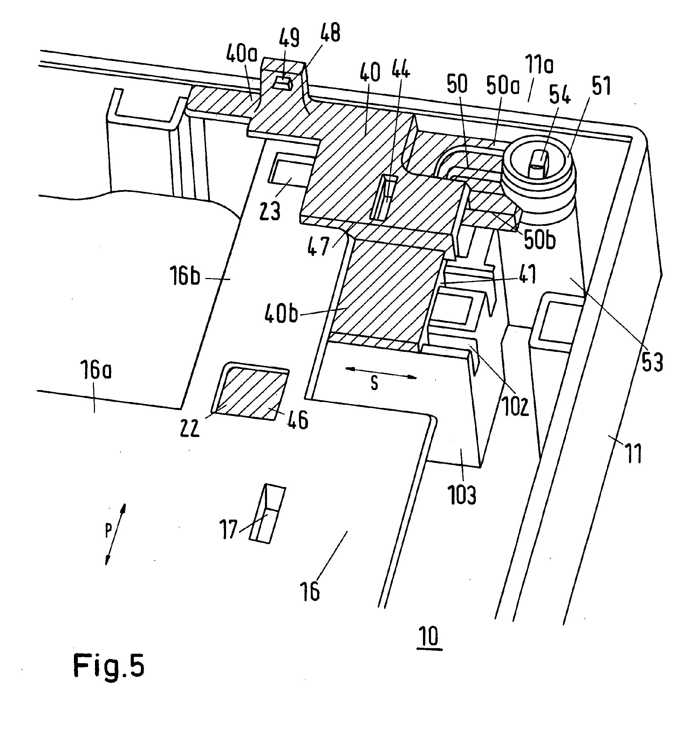

Die Erfindung soll nun beispielhaft anhand der Figuren 4 bis 10 erläutert werden. Die Figur 5 zeigt schematisch eine perspektivische Aufsicht auf eine erfindungsgemäße Plattform 10 mit geöffneter Abdeckplatte. Die Figur 4 zeigt die Ansicht nach Figur 5 mit aufgesetzter Abdeckplatte 12. Gleiche öder gleichwirkende Elemente oder Bauteile tragen dieselben Bezugsziffern wie in den Figuren 1 bis 3.

in der Figur 5 ist der bei montierter Platte 10 obere Teil der Platte 10 zu sehen. In die Kontaktplatte 16 ist gebildet aus einer ersten, rechteckförmigen Teilplatte 16a und einer daran nach obenhin angesetzten, zungenförmigen zweiten Teilplatte 16b. Etwa am Übergang zwischen der ersten Teilplatte 16a und der zweiten Teilplatte 16b befindet sich in der Kontaktplatte 16 ein Durchbruch, der den Kontaktplattenverstellschlitz 22 bildet.

In diesem Kontaktplattenverstellschlitz 22 kann von außen in durch die Kontaktplattenverstellöffnung 21 in der Adapterplatte 12 hindurch mit einem Werkzeug eingegriffen werden, um die Kontaktplatte zu verschieben. Am freien Ende der zungenförmigen, zweiten Teilplatte 16b befindet sich eine weitere Ausnehmungen 23, die zur Plombierung der Kontaktplatte dient, wie weiter unten erläutert wird.

Die Kontaktplatte 16 ist in Längserstreckungsrichtung des Gehäuses der Plattform, angedeutet durch den Doppelpfeil P, verschiebbar.

Die Kontakteinrichtungen, Kontakttulpen und Brücke, sind unter der Kontaktplatte 16 verdeckt und in den Figuren 4 bis 10 nicht sichtbar.

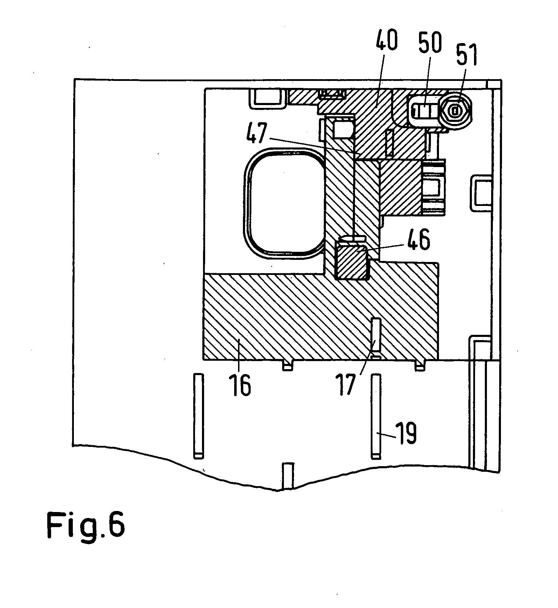

Zusätzlich zu der Kontaktplatte 16 ist zwischen der Abdeckplatte 12 und den Kontakteinrichtungen eine weitere, so genannte Steuerplatte 40 vorhanden. Sie ist in den Figuren 4 und 5 schraffiert, und in den Figuren 6 bis 10 eng schraffiert dargestellt. Die Steuerplatte 40 ist parallel zu der Abdeckplatte 12 und senkrecht zur Verschieberichtung in der Kontaktplatte es 16 verschiebbar, angedeutet durch den Doppelpfeil S. Dazu sind an der Steuerplatte 40 senkrecht in Richtung des Gehäusebodens weisende und in Verschieberichtung es verlaufende Federn angeformt, die in entsprechenden Nuten 102 in einem von dem Gehäuseboden sich erhebenden Führungsblock 103 verlaufen. Die Steuerplatte 40 wird dabei durch ein Werkzeug verschoben, das von außen durch eine Steuerplattenverstellöffnung 42 in der Abdeckplatte 12 in einen Steuerplattenverstellschlitz 44 in der Steuerplatte 40 eingreift.

Die Steuerplatte ist als ungefähr T-förmiges, im wesentlichen flaches Bauteil ausgebildet. Der Querbalken 40a verläuft parallel zur Schmalseite 11a des Gehäuses der Plattform 10, der Längsbalken 40b verläuft parallel zu der Längserstreckungsrichtung der Kontaktplatte 16.

Die Figuren 4 und 5 zeigen in die Kontaktplatte 16 in der Auslieferungsposition und die Steuerplatte 40 in der Verriegelungsposition.

Das freie Ende des Längsbalkens 40b läuft in einem flachen Steg aus, der ein Steuerplattenverriegelungsmittel 46 bildet. Ein weiteres Steuerplattenverriegelungsmittel ist gebildet in der Nähe des Kreuzungspunktes des Querbalkens 40a mit dem Längsbalken 40b, indem dort eine stufenförmige Ecke 47entsteht.

In der in der Figur 5 gezeigten Position im greift die stufenförmigen Ecke 47 in einen damit korrespondierende Schlitz förmige Ausnehmung an der zweiten, zungenförmigen Teilplatte 16b der Kontaktplatte 16 ein. Dadurch ist ein Verschieben in der Kontaktplatte 16 senkrecht zu dem Querbalken 40 war der Steuerplatte 40 verhindert. Da die Steuerplatte 40 in den beiden Nuten 102 fest geführt ist, ist somit insgesamt ein Verschieben der Kontaktplatte 16 in dieser Position nicht mehr möglich. Die Kontaktplatte 16 ist durch die Steuerplatte 40 fest verriegelt. Zusätzlich ist in der gezeigten Position nach Figur 5 der flache Steg 46 so unter die Kontaktplatte 16 geschoben, dass er den Kontaktplattenverstellschlitz 22 von unten her abdeckt. Es ist jetzt nicht mehr möglich, von außen mit einem Werkzeug durch die Kontaktplattenverstellöffnung 21 in der Abdeckplatte 12 hindurch in diesem Kontaktplattenverstellschlitz 22 einzugreifen, um die Kontaktplatte 16 möglicherweise mit Gewalt noch in die Montageposition zu verbringen.

In der gezeigten Verriegelungsposition nach Figur 5 und 6 kann die Steuerplatte 40 auf zwei Arten plombiert werden. Ein erstes Steuerplattenplombiermittel 50 ist gebildet durch einen nach außen hin offenen Schlitz mit zwei Schenkeln 50a, 50b an dem freien Ende des Querbalkens 40a der Steuerplatte 40. Korrespondierend zu der Öffnung des Schlitzes 50 ist in einem mit dem Gehäuse verbundenen Führungszapfen 53 ein Plombierfinger 51 drehbar gelagert. Die Drehachse des Plombierfingers 51 steht senkrecht auf dem Gehäuseboden und senkrecht zur Verschieberichtung der Steuerplatte 40. Der Plombierfinger 51 hat eine ovale Querschnittskontur. In der in der Figur 5 gezeigten Verriegelungsposition ist der Finger 51 so ausgerichtet, dass die Längsachse seiner ovalen Querschnittskontur quer zu der Schlitzöffnung steht. Der Finger 51 blockiert in dieser Position ein Verschieben der Steuerplatte 40, den die Schenkel 50a, 50b in des Schlitzes 50 können den querliegenden Finger 51 nicht umfassen. An der nach außen weisenden Oberseite befindet sich in dem Finger 51 eine kreisförmige Einsenkung, aus deren Mitte sich ein Codierzapfen 54 erhebt. Die Einsenkung und der Codierzapfen 54 sind so speziell geformt, dass nur mit einem besonderen Werkzeug, das die komplementäre Oberflächenkontur aufweist, nach dem Schlüssel - Schloss - Prinzip eingegriffen werden kann, um den Plombierfinger 51 zu verdrehen. Wenn mit diesem besonderen Werkzeug der Plombierfinger 51 um 90° aus der in Figur 5 gezeigten Verriegelungsposition verdreht wird, dann weist die Längsachse der ovalen Querschnitts Kontur des Plombierfinger es 51 in Richtung der Schlitzöffnung. In dieser Position können die Schenkel 50a, 50b den Plombierfinger 51 umfassen, und ein Verschieben der Steuerplatte 40 in Richtungs der Freigabeposition ist es möglich. Eine Plombiereinrichtung mit einem solchen Plombierfinger wird auch als "Anti - Lux - Einrichtung" und das spezielle Werkzeug entsprechend als "Anti - Lux - Werkzeug" bezeichnet. Die Öffnung in der Abdeckplatte 12, durch die hindurch das" Anti - Lux - Werkzeug" eingreift, wird entsprechend auch" Anti - Lux - Öffnung" 52 genannt:

Die zweite Plombiermöglichkeit der Steuerplatte 40 in der Verriegelungsposition ist durch ein zweites Steuerplattenplombiermittel in Form einer von der Steuerplatte nach außen weisenden Plombierzunge 48 mit einer Plombieröffnung 49 gegeben. Die Plombierzunge 48 ist mit einer ein zweites Plattformplombiermitteln bildenden Plombierlasche 55 mit ebenfalls einer Plombieröffnung ausgerichtet, so dass die beiden Plombieröffnung in in der Plombierlasche 55 und in der Plombierzunge 48 in der Verriegelungsstelle um der Steuerplatte 40 so einander gegenüberstehen, dass sie durch einen Plombierdraht plombiert werden können.

In der Auslieferungsposition nach Figur 5 kann auch die Kontaktplatte 16 plombiert werden, und zwar durch ein Bügelschloss, das in die Kontaktplattenplombieröffnung 23 eingesetzt wird. Die Kontaktplattenplombieröffnung 23 korrespondiert dabei mit einer Plombieröffnung 56 in der Abdeckplatte 12, die so bemessen ist, dass das Bügelschloss, wenn es in die Kontaktplattenplombieröffnung 23 eingesetzt ist, in der Plombieröffnung 56 gehalten ist und ein Verschieben der Kontaktplatte 16 verhindert.

Die Figur vier zeigt die verschiedenen Plombiermöglichkeiten bei geschlossener Plattform, das heißt, die Abdeckplatte 12 ist auf das Gehäuse 101 aufgesetzt. Man erkennt, dass die Kontaktplattenverstellöffnung 21 durch das Steuerteil 40 abgedeckt ist, so dass der Kontaktplattenverstellschlitz 22 von außen nicht zum Eingriff durch ein Werkzeug zugänglich sind. An dem Kontaktplattenverstellöffnung 21 und der Steuerplattenverstellöffnung 42 auf der Abdeckplatte 12 sind die Positionen der Kontaktplatte 16 mit den eingravierten Buchstaben "P" für die Auslieferungsposition und "P" für die Montageposition gekennzeichnet, sowie die Positionen der Steuerplatte 40 mit den eingravierten Buchstaben "P" für die Verriegelungsposition und "M" für die Freigabeposition gekennzeichnet, so dass die jeweilige Position der Kontaktplatte beziehungsweise der Steuerplatte von außen erkennbar ist.

Die Figuren 6 bis 10 zeigen nochmals schematisch in einer Aufsicht auf die geöffnete Adapterplatte die verschiedenen möglichen Positionen der Steuerplatte 40 im Verhältnis zur Kontaktplatte 16. Die Figur 6 entspricht der oben bereits anhand der Figuren 4 und 5 beschriebenen Position, in der die Kontaktplatte 16 sich in der Auslieferungsposition und Steuerplatte 40 sich in der Verriegelungsposition befindet und darin durch die Antilux Einrichtung, gebildet durch den Finger 51 und den Schlitz 50, plombiert ist. Es wird hier auch deutlich, dass in dieser Position ein Stromzähler nicht aufgesetzt werden kann, in dem in der Kontaktplattenschlitz 17 liegt nicht unterhalb des Abdeckplattenschlitzes 19.

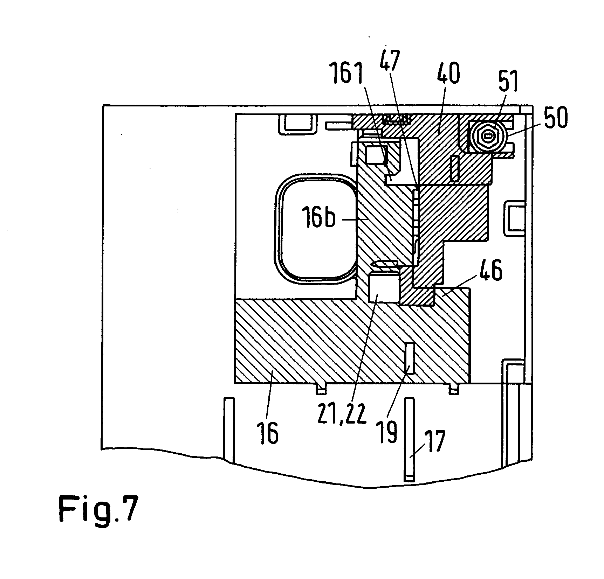

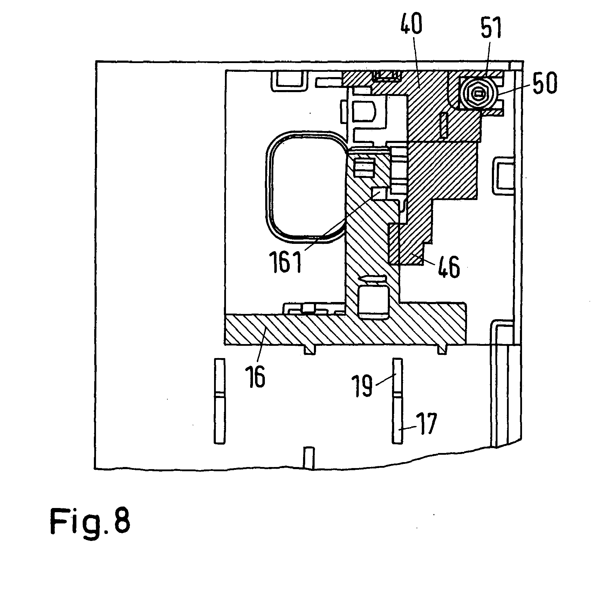

in der Position nach Figur 7 wurde der Finger 51 gegenüber der Position aus Figur 6 um 90° gedreht, so dass nunmehr der Schlitz 50 den Finger 51 umfassen kann. Entsprechend wurde in der Position nach Figur 7 die Steuerplatte 40 in ihre Freigabeposition verschoben. Man erkennt als Kontaktplattenverriegelungsmittel 161 eine Ausnehmung in der zweiten Teilplatte 16b, die in der Position nach Figur 6 noch mit der Ecke 47 zusammengewirkt hatte, und dadurch ein Verschieben der Kontaktplatte 16 relativ zur Steuerplatte 40 verhindert war. In der Position nach Figur 7 ist diese Verzahnung aufgehoben. Außerdem gibt der Steg 46 in den Kontaktplattenverstellschlitz 22 nun frei, so dass die Kontaktplatte in 16 durch ein Werkzeug nunmehr in die Montageposition nach Figur 8 verschoben werden kann.

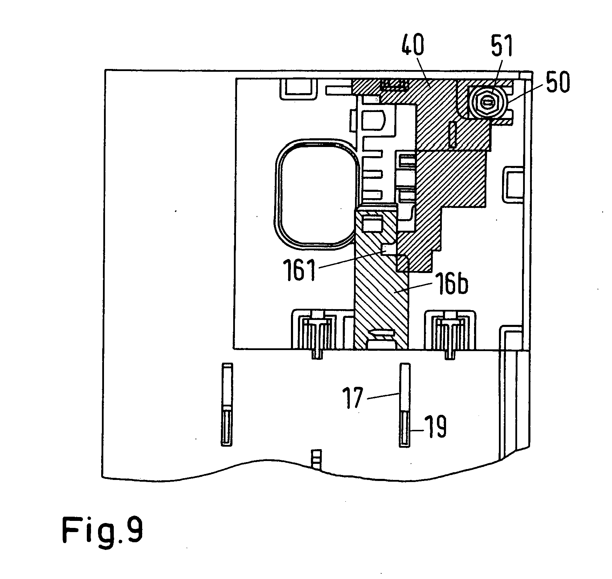

In der Position nach Figur 8 ist die Kontaktplatte 16 ein Stück nach unten in ihre Montageposition verschoben. Der Abdeckplattenschlitze 19 und der Kontaktplattenschlitz 17 liegen übereinander, so dass nun ein elektronischer Haushaltszählern mit seinem Kontaktfahnen durch den Abdeckplattenschlitze 19 und den Kontaktplattenschlitz 17 hindurch eingesetzt werden kann. Durch weiteres Verschieben nach unten nimmt der Haushaltszähler mitseinen Kontaktfahnen die Kontaktplatte 16 und die darunter gelegenen Kontaktbrücken mit, um in seine Betriebsposition zu gelangen, die in der Figur 9 dargestellt ist. Der Haushaltszähler ist in der Figur 9 nicht dargestellt.

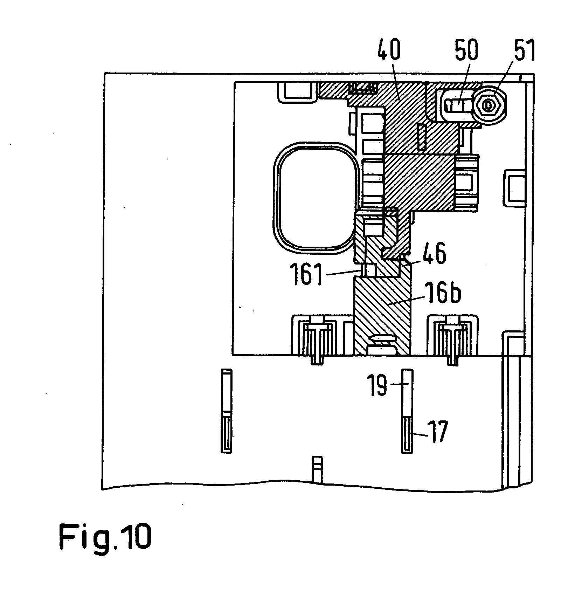

In der Betriebsposition nach Figur neun kann nun die Kontaktplatte 16 durch die Steuerplatte 40 wieder verriegelt werden, indem die in dem die Steuerplatte 40 wieder nach links in Richtung ihrer Verriegelungsposition verschoben wird. Diese Stellung ist in der Figur 10 dargestellt.. Das Steuerplattenverriegelungsmittel in Forum des Stielike 46 greift jetzt in das Kontaktplattenverriegelungsmittel 161 in Form des Schlitzes der Längsseite der zweiten Teilplatte 16b ein und blockiert eine Bewegung der Kontaktplatte 16 relativ zur Steuerplatte 40. Damit ist es nicht mehr möglich, den Stromzähler aus seiner Betriebsposition in die Montageposition zu bringen, den diese Bewegung wird durch die Blockade der Kontaktplatte verhindert. Die Steuerplatte 40 kann in dieser Position wieder auf zwei Arten plombiert werden, nämlich durch die gezeigte Antilux-Vorrichtung 51,50 oder durch die Plombierlasche 55 im Zusammenwirken mit der Plombieröffnung 49.

Mit der erfindungsgemäßen Abdeckplatte kann also bei aufgesetztem Zähler dessen Entnahme aus der Arbeitsposition wirksam verhindert werden, indem die Steuerplatte 40 in ihre Verriegelungsposition gebracht wird, in der sie das Verschieben der Kontaktplatte aus der Arbeitsposition in die Montageposition verhindert, und dort doppelt plombiert werden kann, nämlich erstens durch einen Plombierdraht durch die Plombieröffnung 49 und die Plombierlasche 55 und zweitens durch die Antilux Einrichtung 51,50.

Damit ist eine sehr wirksame Methode entwickelt worden, um die Missbrauchsmöglichkeit des elektronischen Stromzählers auf der Adapterplatte deutlich zu erschweren.

Es soll nicht unerwähnt bleiben, dass selbstverständlich zusätzlich zu den in dem Ausführungsbeispiel beschriebenen Ausführungsformen auch noch allen anderen denkbaren Plombiermöglichkeiten mit einer erfindungsgemäßen Plattform kombiniert werden können und dann ebenfalls unter die angegebene Erfindung fallen. So könnten beispielsweise zusätzlich noch Plombiervorrichtungen vorgesehen sein, mit denen der Zähler selbst an der Plattform in seiner Montageposition plombiert werden kann, sei es durch Plombierstecker, Plombierschrauben oder ähnliches.

### Bezugszeichenliste

- 10: Plattform
- 101: Gehäuse
- 11: Gehäuseunterteil
- 102: Nuten
- 103: Führungsblock
- 11a: Schmalseite
- 12: Abdeckplatte
- 13: Kontakttulpe
- 14: Kontakttulpe
- 15: Brücke
- 16: Kontaktplatte
- 16a: erste Teilplatte
- 16b: zweite Teilplatte
- 161: Kontaktplattenverriegelungsmittel
- 17: Kontaktplattenschlitz
- 18: Kontaktplattenschlitz
- 19: Abdeckplattenschlitz
- 20: Abdeckplattenschlitz
- 21: Kontaktplattenverstellöffnung
- 22: Kontaktplattenverstellschlitz
- 23: Kontaktplattenplombieröffnung
- 27: Erste Brückenaussparung
- 28: Zweite Brückenaussparung
- 29: Erster Kontaktplattenvorsprung
- 30: Zweiter Kontaktplattenvorsprung
- 31: Endkante des Kontaktplattenschlitzes
- 32: Endkante des Kontaktplattenschlitzes
- 33: Endkante des Abdeckplattenschlitzes
- 34: Endkante des Abdeckplattenschlitzes
- 35: Stromzähler
- 36: Anschlussfahne
- 37: Anschlussfahne
- 40: Steuerteil
- 40a: Querbalken
- 40b: Längsbalken
- 42: Steuerplattenverstellöffnung
- 44: Steuerplattenverstellschlitz
- 46: Steuerplattenverriegelungsmittel
- 47: Ecke
- 48: Plombieröse (Steuerplattenplombiermittel)
- 49: Plombieröffnung
- 50: Gabelförmige Ausnehmung (Steuerplattenplombiermittel)
- 50a, 50b: Schenkel
- 51: Plombierfinger
- 52: Antilux-Öffnung
- 53: Führungszapfen
- 54: Codierzapfen
- 55: Plombierlasche
- 56: Plombieröffnung in der Abdeckplatte

## Patentansprüche

1. Plattform (10) mit einem rechteckförmigen Gehäuse (101) zum Aufstecken eines Stromzählers (35),
- mit einer Abdeckplatte (12) mit Abdeckplattenschlitzen (19, 20) zum Durchstecken von Anschlussfahnen (36, 37) des Stromzählers (35), die in einer Betriebsposition mit Kontakteinrichtungen (13, 14, 15) im Inneren der Plattform (10) in elektrisch leitende Verbindung gelangen,
- und mit einer zwischen der Abdeckplatte (12) und den Kontakteinrichtungen (13, 14, 15) angeordneten Kontaktplatte (16), die von außerhalb der Plattform (10) zwischen einer Auslieferungs-, einer Montage- und einer Betriebsposition verschiebbar ist, und die Kontaktplattenschlitze (17, 18) aufweist, deren Zusammenwirken mit den Abdeckplattenschlitzen (19, 20) so eingerichtet ist, dass in der Auslieferungsposition die Kontaktplattenschlitze (17, 18) und die Abdeckplattenschlitze (19, 20) seitlich versetzt sind, so dass die Abdeckplattenschlitze (19, 20) durch die Kontaktplatte (16) verdeckt sind, und dass in der Montage- und der Betriebsposition die Kontaktplattenschlitze (17,18) sich unterhalb der Abdeckplattenschlitze (19,20) befinden,
**gekennzeichnet durch** ein unterhalb der Abdeckplatte (12) angeordnetes, mit der Kontaktplatte (16) zusammenwirkendes und von außerhalb der Plattform (10) zwischen einer Verriegelungsposition und einer Freigabeposition verschiebbares Steuerteil (40), dessen Zusammenwirken mit der Kontaktplatte (16) so eingerichtet ist, dass in der Verriegelungsposition des Steuerteils (40) ein Verschieben der Kontaktplatte (16) aus der Auslieferungs - in die Montageposition und aus der Betriebs - in die Montageposition verhindert ist, und in der Freigabeposition des Steuerteils (40) die Kontaktplatte (16) zur Verschiebung zwischen der Auslieferungs -, der Montage - und der Betriebsposition freigegeben ist.

2. Plattform (10) nach Anspruch 1, wobei das Steuerteil als Steuerplatte (40) ausgebildet ist.

3. Plattform (10) nach Anspruch 2, wobei das Verschieben der Kontaktplatte (16) parallel zur Längserstreckungsrichtung der Plattform (10) und das Verschieben der Steuerplatte (40) senkrecht zur Verschieberichtung der Kontaktplatte (16) erfolgt.

4. Plattform (10) nach einem der vorigen Ansprüche, wobei das Verschieben der Kontaktplatte (16) zwischen der Auslieferungs- und der Montageposition mittels eines durch eine Kontaktplattenverstellöffnung (21) in der Abdeckplatte (12) in einen Kontaktplattenverstellschlitz (22) in der Kontaktplatte (16) einführbaren Werkzeugs, und das Verschieben der Steuerplatte (40) zwischen der Verriegelungs- und der Freigabeposition mittels eines durch eine Steuerplattenverstellöffnung (42) in der Abdeckplatte (12) in einen Steuerplattenverstellschlitz (44) in der Steuerplatte (40) einführbaren Werkzeugs erfolgt.

5. Plattform (10) nach Anspruch 4, wobei die Steuerplatte (40) so gestaltet ist und relativ zu der Kontaktplatte (16) angeordnet und verschiebbar ist, dass in der Auslieferungsposition der Kontaktplattenverstellschlitz (22) in der Kontaktplatte (16) durch die Steuerplatte (40) verdeckt ist, so dass in der Auslieferungsposition der Zugang des Werkzeugs zum Kontaktplattenverstellschlitz (22) blockiert ist.

6. Plattform (10) nach Anspruch 5, wobei die Steuerplatte (40) Steuerplattenverriegelungsmittel (46) und die Kontaktplatte (16) Kontaktplattenverriegelungsmittel (161) umfassen, die in der Verriegelungs- Position der Steuerplatte (40) so miteinander in Eingriff stehen, dass eine Bewegung der Kontaktplatte (16) relativ zur Steuerplatte (40) verhindert ist.

7. Plattform (10) nach einem der vorigen Ansprüche, wobei die Steuerplatte (40) Steuerplattenplombiermittel (48,50) umfasst, mittels derer sie in ihrer Verriegelungsposition mit Plattformplombiermitteln der Plattform (10) plombierbar ist.

8. Plattform (10) nach Anspruch sieben, wobei die Steuerplatte wenigstens zwei Steuerplattenplombiermittel (48,50) umfasst, mittels derer sie in ihrer Verriegelungsposition mit wenigstens zwei Plattformplombiermitteln der Plattform (10) plombierbar ist.

9. Plattform (10) nach einem der vorigen Ansprüche, wobei die Kontaktplatte (16) Kontaktplattenplombiermittel umfasst, mittels derer sie in ihrer Auslieferungsstellung mit der Plattform (10) plombierbar ist.

10. Plattform (10) nach einem der vorigen Ansprüche, wobei das Steuerteil (40) ein etwa T- förmiges, flaches Bauteil ist, dessen erste Querbalken parallel zur Schmalseite des Gehäuses (101) der Plattform, und dessen zweiter Querbalken parallel zur Verschieberichtung der Kontaktplatte (16) verläuft.

11. Plattform (10) nach einem der Ansprüche 6 bis 10, wobei das Steuerplattenverriegelungsmittel (46) einen an dem zweiten Querbalken des Steuerteils (40) angeformten Steg umfasst.

12. Plattform (10) nach einem der Ansprüche 6 bis 11, wobei das Kontaktplattenverriegelungsmittel (161) wenigstens eine Ausnehmung an der Längsseite der Kontaktplatte (16) umfasst.

13. Plattform (10) nach Anspruch 12, wobei zwei Ausnehmungen an der Längsseite der Kontaktplatte (16) vorgesehen und derart in Abstand voneinander angeordnet sind, dass in der Auslieferungsposition der Kontaktplatte (16) der Steg mit der ersten Ausnehmung, und in der Betriebsposition der Kontaktplatte (16) der Steg mit der zweiten Ausnehmung in Eingriff steht.

14. Plattform (10) nach einem der Ansprüche 6 bis 13, wobei der Steg so ausgebildet und an der Steuerplatte (40) angeordnet ist, dass er bei sich in der Plombierposition befindlichen Kontaktplatte (16) und sich in der Verriegelungsstellung befindlichen Steuerplatte (40) der Kontaktplattenverstellschlitz (22) in der Kontaktplatte (16) durch den Steg verdeckt ist.

15. Plattform (10) nach einem der Ansprüche 7 bis 14, wobei ein erstes Steuerplattenplombiermittel (50) einen in Richtung der Freigabeposition hin offenen Schlitz (50) an einem freien Ende des Querbalkens (40a) der Steuerplatte (40) und ein erstes Plattformplombiermittel einen an dem Gehäuse beweglich gelagerten und durch eine Antilux-Öffnung (52) in der Abdeckplatte (12) mittels eines Antilux-Werkzeugs zwischen einer Sperrposition und einer Öffnungsposition bewegbaren Finger (51) umfasst, derart, dass in der Sperrposition des Fingers (51) dieser die Steuerplatte (40) in der Verriegelungsposition festhält, und in der Öffnungsposition des Fingers (51) dieser und der Schlitz (50) gegeneinander verschiebbar sind.

16. Plattform (10) nach einem der Ansprüche 7 bis 15, wobei ein zweites Steuerplattenplombiermittel (48) eine Zunge mit einer Plombieröffnung (59), und ein zweites Plattformplombiermittel eine an dem Gehäuse der Plattform (10) angeformte Plombierlasche (55) mit einer weiteren Plombieröffnung umfasst, derart das in der Verriegelungsposition der Steuerplatte (40) die Plombieröffnung (49) an der Zunge und die weitere Plombieröffnung an der Plombierlasche (55) miteinander fluchten und durch einen Plombierdraht miteinander plombierbar sind.

17. Plattform (10) nach Anspruch 9, wobei das Kontaktplattenplombiermittel eine Kontaktplattenplombieröffnung (23) umfasst, die in der Auslieferungsposition der Kontaktplatte (16) durch eine Öffnung (56) im Gehäuse der Plattform (10) für ein Plombierschloss zum Plombieren mit der Plattform (10) zugänglich ist.
